# EUROPÄISCHE PATENTSCHRIFT

(11) **EP 4 158 226 B1**
(45) Veröffentlichungstag und Bekanntmachung des Hinweises auf die Patenterteilung: **10.01.2024**
(21) Anmeldenummer: 21720437.9
(22) Anmeldetag: 19.04.2021
(51) Int. Cl.: H10N 10/17, H10N 10/13, F16J 15/34

(54) **GLEITRINGDICHTUNGSANORDNUNG MIT PELTIER-ELEMENT**
MECHANICAL SEAL ASSEMBLY WITH PELTIER ELEMENT
ENSEMBLE JOINT MÉCANIQUE DOTÉ D'UN ÉLÉMENT PELTIER

(30) Priorität: 28.05.2020 DE 102020114290
(43) Veröffentlichungstag der Anmeldung: 05.04.2023
(73) Patentinhaber: EagleBurgmann Germany GmbH & Co. KG, 82515 Wolfratshausen (DE)
(72) Erfinder: MÜLLER, Michael, 83673 Bichl (DE); KREFT, Stefanie, 81369 München (DE)
(74) Vertreter: Hoefer & Partner Patentanwälte mbB
(86) Internationale Anmeldenummer: PCT/EP2021/060110
(87) Internationale Veröffentlichungsnummer: WO 2021/239332

(56) Entgegenhaltungen:
- JP-U- S5 697 659
- SU-A1- 576 463
- SU-A1- 1 634 907
- US-A1- 2014 345 664
- US-A1- 2014 355 644

## Beschreibung

Die vorliegende Erfindung betrifft eine Gleitringdichtungsanordnung mit einem Peltier-Element zur Erzeugung von elektrischem Strom, um eine Sensoreinrichtung der Gleitringdichtungsanordnung mit elektrischem Strom zu versorgen.

Gleitringdichtungsanordnungen sind aus dem Stand der Technik in unterschiedlichen Ausgestaltungen bekannt. Um eine Überwachung der Gleitringdichtungsanordnung zu realisieren und möglichst frühzeitig einen möglichen Ausfall der Gleitringdichtungsanordnung vorhersagen zu können, werden unterschiedliche physikalische Werte im Bereich der Gleitringdichtung erfasst und überwacht. Hierzu werden Sensoreinrichtungen verwendet, welche üblicherweise kabelgebunden sind. Dadurch ist es nicht möglich, am rotierenden Gleitring direkt Werte aufzunehmen. Ferner ist die Verkabelung gegebenenfalls ein erheblicher Aufwand, was derartige Gleitringdichtungsanordnungen deutlich verteuert. Weiterhin sind grundsätzlich Sensoreinrichtungen bekannt, welche autark, beispielsweise mit einer Batterie zur elektrischen Stromversorgung, arbeiten können. Derartige Sensoreinrichtungen könnten zwar beispielsweise bei einem rotierenden Gleitring verwendet werden, allerdings ergeben sich durch die Verwendung der Batterie nur begrenzte Nutzungsdauern, so dass ein häufiger Austausch derartiger Batterien nötig wäre, was zu häufigen Unterbrechungen der mit der Gleitringdichtungsanordnung abgedichteten Maschine führen würde. Da üblicherweise ein Batterieaustausch vor einem eigentlichen Wartungsintervall der Gleitringdichtungsanordnung erfolgen muss, ergeben sich dadurch eine Vielzahl unerwünschter Stillstände. Von daher wird üblicherweise auf die Verwendung von Sensoren direkt an rotierenden Bauteilen der Gleitringdichtungsanordnung verzichtet.

JP S56 97659 U und SU 576 463 A1 beschreiben Gleitringdichtungen, welche die Verwendung des Peltier-Effekts zur Kühlung eines stationären Gleitrings vorschlagen. SU 1 634 907 A1 offenbart eine Gleitringdichtungsanordnung gemäß der Präambel von Anspruch 1.

Es ist daher Aufgabe der vorliegenden Erfindung, eine Gleitringdichtungsanordnung bereitzustellen, welche bei einfachem Aufbau und einfacher, kostengünstiger Herstellbarkeit eine verlängerte Nutzungsdauer von Sensoreinrichtungen ermöglicht und insbesondere eine Nutzung von Sensoreinrichtungen direkt an rotierenden Bauteilen der Gleitringdichtungsanordnung ermöglicht.

Diese Aufgabe wird durch eine Gleitringdichtungsanordnung mit den Merkmalen des Anspruchs 1 gelöst. Die Unteransprüche zeigen bevorzugte Weiterbildungen der Erfindung.

Die erfindungsgemäße Gleitringdichtungsanordnung mit den Merkmalen des Anspruchs 1 weist den Vorteil auf, dass eine vereinfachte Nutzung und Montage von Sensoreinrichtungen an Bauteilen der Gleitringdichtungsanordnung möglich ist. Insbesondere kann auf einfache Weise eine Sensoreinrichtung an einem rotierenden Bauteil der Gleitringdichtungsanordnung, beispielsweise an einem rotierenden Gleitring oder einem rotierenden Gleitringträger, angeordnet werden. Dies wird erfindungsgemäß dadurch erreicht, dass die Gleitringdichtungsanordnung eine Gleitringdichtung mit einem rotierenden und einem stationären Gleitring aufweist, welche zwischen einer ersten und einer zweiten Gleitfläche einen Dichtspalt definieren. Ferner ist eine Sensoreinrichtung vorgesehen, welche einen Sensor und eine Stromversorgungseinrichtung umfasst. Die Stromversorgungseinrichtung ist dabei ein Peltier-Element. Das Peltier-Element umfasst einen ersten und einen zweiten Keramikkörper sowie eine zwischen dem ersten und zweiten Keramikkörper angeordnete Vielzahl von Halbleiterelementen. Dabei erzeugt das Peltier-Element basierend auf vorhandenen Temperaturunterschieden an den Keramikkörpern elektrischen Strom, welcher zur Stromversorgung des Sensors der Sensoreinrichtung verwendet wird. Somit kann durch das Peltier-Element auch ein Sensor an einem rotierenden Bauteil der Gleitringdichtungsanordnung mit elektrischem Strom versorgt werden. Das Peltier-Element erzeugt dabei elektrischen Strom ohne bewegbare Bauteile und kann einfach und kostengünstig montiert werden. Dabei können geometrische Abmessungen des Peltier-Elements sehr klein gehalten werden und das Peltier-Element weist auch ein relativ geringes Gewicht auf, so dass eine Montage an einem rotierenden Bauteil der Gleitringdichtungsanordnung möglich ist und keine Unwucht oder dergleichen erzeugt. Da Gleitringdichtungsanordnungen üblicherweise immer im Bereich von Wellenenden von rotierenden Maschinen oder dergleichen angeordnet sind, herrschen im Bereich der Gleitringdichtungsanordnungen immer relativ große Temperaturunterschiede, welche durch die Idee der Nutzung eines Peltier-Elements genutzt werden können, um elektrischen Strom herzustellen. Somit kann eine Nutzungsdauer des Sensors der Sensoreinrichtung im Vergleich mit ausschließlich batteriebetriebenen Sensoren deutlich verlängert werden. Das Peltier-Element kann dabei auch zusätzlich zu einer vorhandenen Batterie der Sensoreinrichtung genutzt werden, um die Batterielebensdauer dadurch zu verlängern.

Vorzugsweise umfasst die Stromversorgungseinrichtung ferner eine Vorrichtung zur Speicherung von elektrischer Energie. Dadurch ergibt sich eine zusätzliche Speichermöglichkeit für elektrische Energie, welche dann genutzt werden kann, wenn das Peltier-Element keinen elektrischen Strom erzeugen kann, beispielsweise bei einem Anlaufen einer abgekühlten Maschine, oder bei einem schwankenden Strombedarf des Sensors und gegebenenfalls weiterer strombenötigender Bauteile der Sensoreinrichtung. Die Vorrichtung zur Speicherung von elektrischer Energie ist vorzugsweise ein Kondensator oder alternativ ein wiederaufladbarer Akku.

Weiter bevorzugt umfasst die Sensoreinrichtung eine Sender-Empfängereinheit und ist kabellos an einem Bauteil der Gleitringdichtungsanordnung, insbesondere an einem rotierenden Bauteil der Gleitringdichtungsanordnung angeordnet. Besonders bevorzugt ist der Sensor dabei direkt am rotierenden Gleitring angeordnet.

Weiter bevorzugt umfasst die Sensoreinrichtung ferner eine Auswerteeinheit. Dadurch kann eine Datenverarbeitung der mittels des Sensors erfassten Daten der Gleitringdichtungsanordnung unmittelbar in der Sensoreinrichtung erfolgen, so dass eine zu übertragende Datenmenge signifikant reduziert werden kann. Insbesondere ist dadurch eine Echtzeit-Datenverarbeitung auf einfache und kostengünstige Weise durchführbar. Somit kann ein Edge-Computing unmittelbar in der Sensoreinrichtung ausgeführt werden.

Gemäß einer weiteren bevorzugten Ausgestaltung der Erfindung ist der erste Keramikkörper des Peltier-Elements einer der Gleitringe, welcher aus einem elektrisch nicht leitenden Material hergestellt ist. Somit kann das Peltier-Element bautechnisch vereinfacht werden, da der üblicherweise als separates Bauteil vorgesehene erste Keramikkörper wegfällt und dafür der Gleitring, der aus einem elektrisch nicht leitenden Material hergestellt ist, verwendet wird. Somit kann ein besonders kleinbauendes Peltier-Element mit signifikant reduziertem Gewicht und signifikant reduzierten Abmessungen verwendet werden.

Weiter bevorzugt umfasst die Gleitringdichtungsanordnung ein System zur Sperrfluidversorgung mit einem Zufluss und einem Abfluss, wobei das Peltier-Element am Zufluss und/oder am Abfluss angeordnet ist. Durch diese geschickte Anordnung des Peltier-Elements ist es möglich, dass Temperaturunterschiede, welche das Sperrfluid üblicherweise beim Zufluss zur Gleitringdichtung und beim Abströmen durch den Abfluss aufweist, ausgenutzt werden können. Üblicherweise dient das Sperrfluid neben einer Schmierfunktion im Dichtspalt der Gleitringdichtung auch zum Abkühlen der Gleitringdichtung und erwärmt sich somit bei der Umspülung der Gleitringdichtung. Das erwärmte Sperrfluid wird dann über den Abfluss abgeführt und in einem Bereich entfernt von der Gleitringdichtung wieder abgekühlt und dann über den Zufluss wieder zugeführt. Da bei einer Gleitringdichtungsanordnung häufig an der Sperrfluidversorgung die größten Temperaturunterschiede zwischen dem zugeführten Sperrfluid und dem abgeführten Sperrfluid vorliegen, kann das Peltier-Element besonders effektiv die Temperaturunterschiede ausnützen, um elektrischen Strom zu erzeugen.

Gemäß einer weiteren alternativen Ausgestaltung der Erfindung ist der Sensor der Sensoreinrichtung direkt an einem der Gleitringe der Gleitringdichtung angeordnet. Hierbei kann der Sensor unmittelbar auf dem Material des Gleitrings angeordnet werden oder der Gleitring weist eine Beschichtung auf, auf welcher dann der Sensor angeordnet ist.

Weiter bevorzugt weist der Gleitring eine Beschichtung auf, welche aus einem elektrisch nicht leitenden Material hergestellt ist und das Peltier-Element ist auf der Beschichtung angeordnet. Dadurch kann als Material für den Gleitring ein Material verwendet werden, welches elektrisch leitfähig ist und trotzdem ein Peltier-Element unmittelbar am Gleitring angeordnet werden.

Ferner ist die Auswerteeinheit eingerichtet, bei Erreichen eines vorbestimmten Schwellenwerts des durch den Sensor erfassten Wertes eine Abfragefrequenz des Sensors zu erhöhen, um eine Vielzahl von Werten zu erfassen. Dadurch kann beispielsweise ein kritischer Zustand der Gleitringdichtungsanordnung früher erkannt und überwacht werden, wenn die Überwachungsfrequenz durch den Sensor bei Erreichen des Schwellenwerts erhöht wird. Beispielsweise kann, wenn der Sensor ein Temperatursensor ist, bei Erreichen einer vorbestimmten Temperatur die Abfragesequenz des Temperatursensors erhöht werden, um genau die weitere Temperaturentwicklung zu überwachen. Sollte die Temperatur weiter auf einen zweiten Schwellenwert steigen, kann ein entsprechendes Alarmsignal von der Sensoreinrichtung abgegeben werden und die Maschine, in welcher die Gleitringdichtungsanordnung abdichtet, abgestellt werden oder andere Gegenmaßnahmen, beispielsweise eine verstärkte Umwälzung eines Sperrfluids zur verstärkten Kühlung, ergriffen werden.

Somit ermöglicht die Erfindung, ein energieautarkes Sensoriksystem mit Peltier-Element bereitzustellen, wobei eine kabellose Anordnung der Sensoreinrichtung mit einer besonders langen Nutzungsdauer kombiniert werden kann.

Nachfolgend werden bevorzugte Ausführungsbeispiele der Erfindung unter Bezugnahme auf die begleitende Zeichnung im Detail beschrieben. In der Zeichnung ist:
- Fig. 1: eine schematische Schnittansicht einer Gleitringdichtungsanordnung gemäß einem ersten Ausführungsbeispiel der Erfindung,
- Fig. 2: eine detaillierte, schematische Teilschnittansicht einer Sensoreinrichtung der Gleitringdichtungsanordnung von Fig. 1, und
- Fig. 3: eine detaillierte, schematische Teilschnittansicht einer Sensoreinrichtung einer Gleitringdichtungsanordnung gemäß einem zweiten Ausführungsbeispiel der Erfindung.

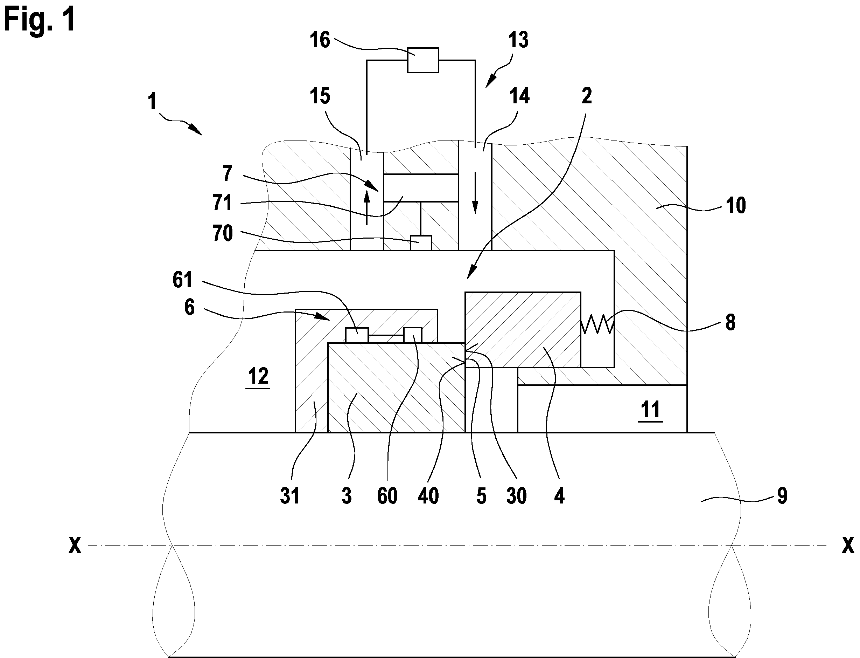

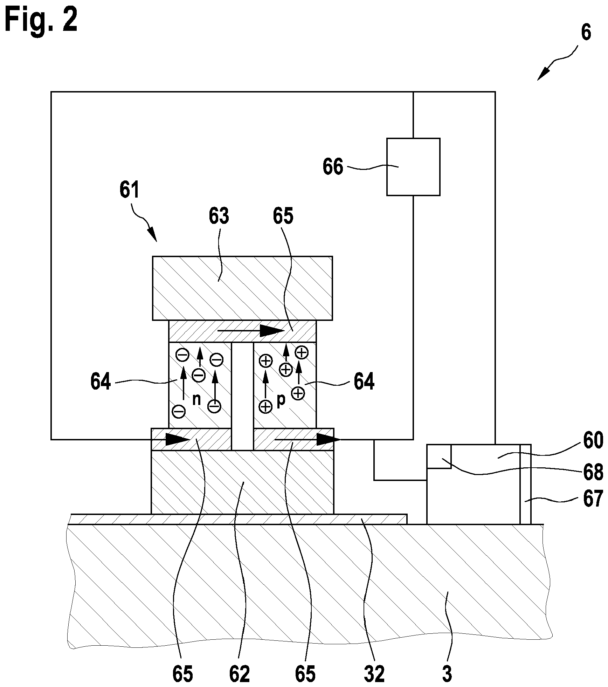

Nachfolgend wird unter Bezugnahme auf die Figuren 1 und 2 eine Gleitringdichtungsanordnung 1 im Detail beschrieben.

Die Gleitringdichtungsanordnung 1 dichtet dabei an einer Welle 9 und einem Gehäuse 10 eine Produktseite 11 von einer Atmosphärenseite 12 ab.

Die Gleitringdichtungsanordnung 1 umfasst eine Gleitringdichtung 2 mit einem rotierenden Gleitring 3 mit einer ersten Gleitfläche 30 und einem stationären Gleitring 4 mit einer zweiten Gleitfläche 40. Zwischen den beiden Gleitflächen 30, 40 ist ein Dichtspalt 5 definiert.

Der rotierende Gleitring 3 ist mittels eines Gleitringträgers 31 an der Welle 9 fixiert und rotiert gemeinsam mit der Welle 9. Der stationäre Gleitring 4 wird mittels einer Vorspanneinrichtung 8 in Axialrichtung X-X vorgespannt.

Die Gleitringdichtungsanordnung 1 umfasst ferner eine erste Sensoreinrichtung 6 mit einem ersten Sensor 60 und einem ersten Peltier-Element 61.

Die erste Sensoreinrichtung 6 ist am rotierenden Gleitring 3 angeordnet und im Detail aus Fig. 2 ersichtlich.

Das erste Peltier-Element 61 umfasst einen ersten Keramikkörper 62 und einen zweiten Keramikkörper 63. Zwischen den beiden Keramikkörpern 62, 63 sind eine Vielzahl von Halbleiterelementen 64 angeordnet. Die Halbleiterelemente 64 sind beispielsweise quaderförmig und mittels Metallbrücken 65, zum Beispiel einem Lot, an einer ersten Seite mit dem ersten Keramikkörper 62 und an einer zweiten Seite mit dem zweiten Keramikkörper 63 verbunden. Die Pfeile in Fig. 2 deuten eine Elektronenflussrichtung an.

Wie weiter aus Fig. 2 ersichtlich ist, weist der rotierende Gleitring 3 eine Beschichtung 32 auf, auf welcher das erste Peltier-Element 61 angeordnet ist. Die Beschichtung 32 ist aus einem Material hergestellt, welches nicht elektrisch leitend ist.

In diesem Ausführungsbeispiel herrscht ein relativ großer Temperaturunterschied zwischen dem rotierenden Gleitring 3 und der Atmosphärenseite 12, welche durch das Peltier-Element 61 ausgenutzt werden kann, um elektrischen Strom zu erzeugen. Der erste Sensor 60 ist dabei mit dem ersten Peltier-Element 61 verbunden, so dass der erzeugte Strom vom ersten Sensor 60 genutzt werden kann, was schematisch in Fig. 2 angedeutet ist.

Die erste Sensoreinrichtung 6 umfasst ferner einen elektrischen Stromspeicher 66. Dieser kann beispielsweise ein Kondensator sein. Sollte überschüssiger Strom vorhanden sein, kann der elektrische Stromspeicher 66 aufgeladen werden. Der derart gespeicherte Strom kann dann, falls das Peltier-Element 61 nicht ausreichend Strom erzeugt, dem Sensor 60 zugeführt werden.

Ferner umfasst der erste Sensor 60 eine Auswerteeinheit 68 für ein Edge-Computing und eine Sender-Empfängereinheit 67 zur Datenübertragung.

Die Gleitringdichtungsanordnung 1 umfasst ferner ein Sperrfluidsystem 13, welches über einen Zulauf 14 Sperrfluid zur Gleitringdichtung 2 zuführt und über einen Ablauf 15 Sperrfluid wieder von der Gleitringdichtung 2 abführt. Das Bezugszeichen 16 bezeichnet dabei eine Pumpe zur Umwälzung des Sperrfluids. Dadurch kann beispielsweise eine Kühlung der Gleitringdichtung 2 im Betrieb durch umgewälztes Sperrfluid vorgenommen werden.

Wie weiter aus Fig. 1 ersichtlich ist, umfasst die Gleitringdichtungsanordnung 1 ferner eine zweite Sensoreinrichtung 7 mit einem zweiten Sensor 70 und einem zweiten Peltier-Element 71. Das zweite Peltier-Element 71 ist mit dem zweiten Sensor 70 verbunden, um diesen mit elektrischem Strom zu versorgen. Wie aus Fig. 1 ersichtlich ist, ist das zweite Peltier-Element 71 im Bereich des Sperrfluidsystems 13 zwischen dem Zulauf 14 und dem Ablauf 15 angeordnet. Dadurch kann das zweite Peltier-Element 71 die Temperaturunterschiede des Sperrfluids im Zulauf 14 und im Ablauf 15 ausnutzen, um elektrischen Strom zu erzeugen.

Somit kann durch die Verwendung von Peltier-Elementen eine einfache und sichere Stromversorgung für Sensoren von Sensoreinrichtungen bei einer Gleitringdichtung 2 verwendet werden. Dabei können die Sensoreinrichtungen sowohl an rotierenden Bauteilen, insbesondere direkt am rotierenden Gleitring 3, oder auch an stationären Bauteilen, beispielsweise dem Gehäuse 10, angeordnet werden. Dabei ist es grundsätzlich möglich, dass das Peltier-Element alleine den Sensor mit elektrischer Energie versorgt oder zusätzlich zu einer am Sensor vorhandenen elektrischen Energiequelle, beispielsweise einer Batterie. Auch ist es möglich, dass durch Verwendung von elektrischen Speichern, beispielsweise Kondensatoren oder wiederaufladbaren Akkus, eine Speicherung von elektrischer Energie möglich ist und so eine Nutzungsdauer der Sensoreinrichtung deutlich verlängert werden kann. Insbesondere kann dann beispielsweise ein Austausch der Sensoreinrichtung gleichzeitig mit einer notwendigen Wartung an der Gleitringdichtungsanordnung vorgenommen werden.

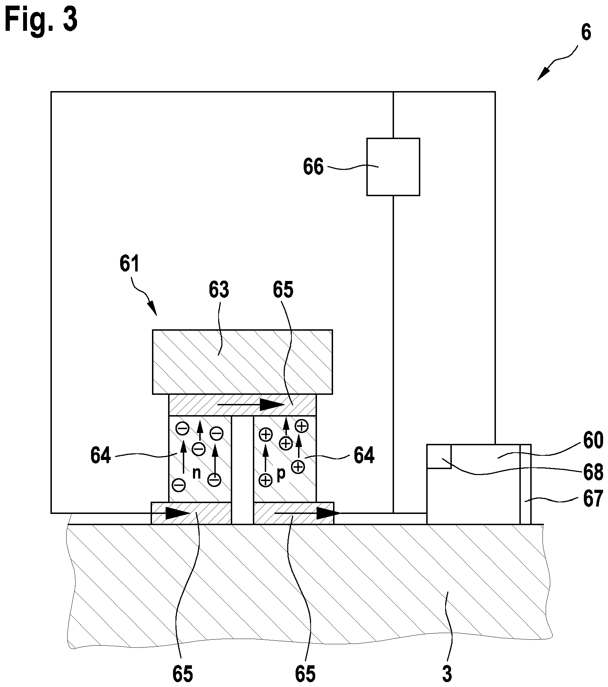

Fig. 3 zeigt eine Sensoreinrichtung 6 einer Gleitringdichtungsanordnung 1 gemäß einem zweiten Ausführungsbeispiel der Erfindung, wobei gleiche bzw. funktional gleiche Teile mit den gleichen Bezugszeichen bezeichnet sind. Im Unterschied zum ersten Ausführungsbeispiel weist das Peltier-Element 6 des zweiten Ausführungsbeispiels einen vereinfachten Aufbau auf. Wie aus Fig. 3 ersichtlich ist, ist das Peltier-Element 61 derart aufgebaut, dass statt eines ersten Keramikkörpers der rotierende Gleitring 3 als Keramikkörper verwendet wird. Somit kann auf einen der Keramikkörper des Peltier-Elements 61 verzichtet werden. Der rotierende Gleitring 3 des zweiten Ausführungsbeispiels ist dabei aus einem elektrisch nicht leitenden Material hergestellt. Ferner ist der erste Sensor 60 direkt auf dem rotierenden Gleitring 3 angeordnet.

Durch diesen Aufbau kann die erste Sensoreinrichtung 6 des zweiten Ausführungsbeispiels noch kompakter und mit reduziertem Gewicht bereitgestellt werden. Dadurch wird insbesondere eine Gefahr einer Unwucht am rotierenden Gleitring 3 durch die erste Sensoreinrichtung 6 signifikant reduziert. Ansonsten entspricht dieses Ausführungsbeispiel dem ersten Ausführungsbeispiel, so dass auf die dort gegebene Beschreibung verwiesen werden kann. Alternativ oder zusätzlich kann auch der stationäre Gleitring 4 als Teil eines Peltier-Elementes verwendet werden.

Neben der vorstehenden schriftlichen Beschreibung der Erfindung wird zu deren ergänzender Offenbarung hiermit explizit auf die zeichnerische Darstellung der Erfindung in den Fig. 1 bis 3 Bezug genommen.

### Bezugszeichenliste

- 1: Gleitringdichtungsanordnung
- 2: Gleitringdichtung
- 3: rotierender Gleitring
- 4: stationärer Gleitring
- 5: Dichtspalt
- 6: erste Sensoreinrichtung
- 7: zweite Sensoreinrichtung
- 8: Vorspanneinrichtung
- 9: Welle
- 10: Gehäuse
- 11: Produktseite
- 12: Atmosphärenseite
- 13: Sperrfluidsystem
- 14: Zulauf von Sperrfluid
- 15: Ablauf von Sperrfluid
- 16: Pumpe
- 30: erste Gleitfläche
- 31: Gleitringträger
- 32: Beschichtung
- 40: zweite Gleitfläche
- 60: erster Sensor
- 61: erstes Peltier-Element
- 62: erster Keramikkörper
- 63: zweiter Keramikkörper
- 64: Halbleiterelement
- 65: Metallbrücke
- 66: elektrischer Stromspeicher
- 67: Sender-Empfängereinheit
- 68: Auswerteeinheit
- 70: zweiter Sensor
- 71: zweites Peltier-Element
- X-X: Axialrichtung

## Patentansprüche

1. Gleitringdichtungsanordnung, umfassend:
- eine Gleitringdichtung (2) mit einem rotierenden Gleitring (3) mit einer ersten Gleitfläche (30) und einem stationären Gleitring (4) mit einer zweiten Gleitfläche (40), welche zwischen sich einen Dichtspalt (5) definieren, wobei die Gleitringdichtungsanordnung
- wenigstens eine Sensoreinrichtung (6, 7) mit einem Sensor (60, 70) und einer Stromversorgungseinrichtung umfasst,
- **dadurch gekennzeichnet, dass** die Stromversorgungseinrichtung ein Peltier-Element (61, 71) ist, welches einen ersten Keramikkörper (62) und einen zweiten Keramikkörper (63) sowie eine zwischen dem ersten und zweiten Keramikkörper (62, 63) angeordnete Vielzahl von Halbleiterelementen (64) aufweist und
- wobei das Peltier-Element (61, 71) basierend auf einem Temperaturunterschied elektrischen Strom zur Stromversorgung des Sensors (60, 70) erzeugt.

2. Gleitringdichtungsanordnung nach Anspruch 1, wobei die Stromversorgungseinrichtung ferner eine Vorrichtung (66) zur Speicherung elektrischer Energie aufweist.

3. Gleitringdichtungsanordnung nach Anspruch 2, wobei die Vorrichtung (66) zur Speicherung elektrischer Energie einen Kondensator und/oder einen wiederaufladbaren Akku umfasst.

4. Gleitringdichtungsanordnung nach einem der vorhergehenden Ansprüche, wobei die Sensoreinrichtung (6, 7) kabellos angeordnet ist und eine Sender-Empfängereinheit (67) umfasst.

5. Gleitringdichtungsanordnung nach einem der vorhergehenden Ansprüche, wobei die Sensoreinrichtung (6, 7) ferner eine Auswerteeinheit (68) aufweist.

6. Gleitringdichtungsanordnung nach einem der vorhergehenden Ansprüche, wobei der erste Keramikkörper des Peltier-Elements einer der Gleitringe (3, 4) ist, wobei dieser Gleitring aus einem elektrisch nicht leitenden Material hergestellt ist.

7. Gleitringdichtungsanordnung nach einem der Ansprüche 1 bis 5, ferner umfassend ein Sperrfluidsystem (13) zur Versorgung der Gleitringdichtung (2) mit Sperrfluid, umfassend einen Zulauf (14) und einen Ablauf (15), wobei das Peltier-Element (71) am Zulauf (14) und/oder am Ablauf (15) angeordnet ist.

8. Gleitringdichtungsanordnung nach einem der vorhergehenden Ansprüche 1 bis 5, wobei der Sensor (60) der Sensoreinrichtung direkt an einem der Gleitringe angeordnet ist.

9. Gleitringdichtungsanordnung nach einem der Ansprüche 1 bis 5, wobei einer der Gleitringe eine Beschichtung (32) aufweist, welche aus einem elektrisch nicht leitenden Material hergestellt ist, wobei das Peltier-Element auf der Beschichtung (32) angeordnet ist.

10. Gleitringdichtungsanordnung nach einem der Ansprüche 5 bis 9, wobei die Auswerteeinheit (68) eingerichtet ist, bei Erreichen eines vorbestimmten Schwellenwerts des durch den Sensor erfassten Wertes eine Abfragefrequenz des durch den Sensor erfassten Wertes zu erhöhen.

## Claims

1. Mechanical seal assembly, comprising:
- a mechanical seal (2) comprising a rotating slide ring (3) having a first sliding surface (30), and a stationary slide ring (4) having a second sliding surface (40), which define a sealing gap (5) therebetween,
- wherein the mechanical seal assembly
- comprises at least one sensor device (6, 7) having a sensor (60, 70) and a power supply device,
- **characterised in that**
the power supply device is a Peltier element (61, 71) which comprises a first ceramic body (62) and a second ceramic body (63), and a plurality of semiconductor elements (64) arranged between the first and second ceramic body (62, 63), and
- wherein the Peltier element (61, 71) generates electrical current for power supply to the sensor (60, 70) based on a temperature difference.

2. Mechanical seal assembly according to claim 1, wherein the power supply device further comprises a device (66) for storing electrical energy.

3. Mechanical seal assembly according to claim 2, wherein the device (66) for storing electrical energy comprises a capacitor and/or a rechargeable battery.

4. Mechanical seal assembly according to any of the preceding claims, wherein the sensor device (6, 7) is arranged wirelessly and comprises a transceiver unit (67).

5. Mechanical seal assembly according to any of the preceding claims, wherein the sensor device (6, 7) further comprises an evaluation unit (68).

6. Mechanical seal assembly according to any of the preceding claims, wherein the first ceramic body of the Peltier element is one of the slide rings (3, 4), wherein said slide ring is produced from an electrically non-conductive material.

7. Mechanical seal assembly according to any of claims 1 to 5, further comprising a barrier fluid system (13) for supplying the mechanical seal (2) with barrier fluid, comprising an intake (14) and an outlet (15), wherein the Peltier element (71) is arranged on the intake (14) and/or on the outlet (15).

8. Mechanical seal assembly according to any of the preceding claims 1 to 5, wherein the sensor (60) of the sensor device is arranged directly on one of the slide rings.

9. Mechanical seal assembly according to any of claim 1 to 5, wherein one of the slide rings comprises a coating (32) which is produced from an electrically non-conductive material, wherein the Peltier element is arranged on the coating (32).

10. Mechanical seal assembly according to any of claims 5 to 9, wherein the evaluation unit (68) is configured to increase an interrogation frequency of the value acquired by the sensor in the event of the value acquired by the sensor reaching a predetermined threshold value.

## Revendications

1. Ensemble garniture d'étanchéité à bague de glissement comprenant :
- une garniture d'étanchéité à bague de glissement (2) avec une bague de glissement rotative (3) avec une première surface de glissement (30) et une bague de glissement stationnaire (4) avec une seconde surface de glissement (40), qui définissent entre elles une fente d'étanchéité (5),
dans lequel l'ensemble de garniture d'étanchéité à bague de glissement
- comprend au moins un dispositif de capteur (6, 7) avec un capteur (60, 70) et un dispositif d'alimentation en courant,
- **caractérisé en ce que**
le dispositif d'alimentation en courant est un élément Peltier (61, 71) qui présente un premier corps en céramique (62) et un second corps en céramique (63) ainsi qu'une pluralité d'éléments semi-conducteurs (64) agencée entre le premier et second corps en céramique (62, 63) et
- dans lequel l'élément Peltier (61, 71) génère, sur la base d'une différence de température, du courant électrique pour l'alimentation en courant du capteur (60, 70).

2. Ensemble garniture d'étanchéité à bague de glissement selon la revendication 1, dans lequel le dispositif d'alimentation en courant présente de plus un dispositif (66) pour le stockage d'énergie électrique.

3. Ensemble garniture d'étanchéité à bague de glissement selon la revendication 2, dans lequel le dispositif (66) pour le stockage d'énergie électrique comprend un condensateur et/ou un accumulateur rechargeable.

4. Ensemble garniture d'étanchéité à bague de glissement selon l'une quelconque des revendications précédentes, dans lequel le dispositif de capteur (6, 7) est agencé sans câble et comprend une unité d'émetteur-récepteur (67).

5. Ensemble garniture d'étanchéité à bague de glissement selon l'une quelconque des revendications précédentes, dans lequel le dispositif de capteur (6, 7) présente de plus une unité d'évaluation (68).

6. Ensemble garniture d'étanchéité à bague de glissement selon l'une quelconque des revendications précédentes, dans lequel le premier corps en céramique de l'élément Peltier est une des bagues de glissement (3, 4), dans lequel cette bague de glissement est fabriquée en un matériau non électroconducteur.

7. Ensemble garniture d'étanchéité à bague de glissement selon l'une quelconque des revendications 1 à 5, comprenant de plus un système de fluide de verrouillage (13) pour l'alimentation de la garniture d'étanchéité à bague de glissement (2) en fluide de verrouillage, comprenant une alimentation (14) et une évacuation (15), dans lequel l'élément Peltier (71) est agencé au niveau de l'alimentation (14) et/ou au niveau de l'évacuation (15).

8. Ensemble garniture d'étanchéité à bague de glissement selon l'une quelconque des revendications précédentes 1 à 5, dans lequel le capteur (60) du dispositif de capteur est directement agencé au niveau d'une des bagues de glissement.

9. Ensemble garniture d'étanchéité à bague de glissement selon l'une quelconque des revendications 1 à 5, dans lequel une des bagues de glissement présente un revêtement (32) qui est fabriqué en un matériau non électroconducteur, dans lequel l'élément Peltier est agencé sur le revêtement (32).

10. Ensemble garniture d'étanchéité à bague de glissement selon l'une quelconque des revendications 5 à 9, dans lequel l'unité d'évaluation (68) est conçue afin d'augmenter, lors de l'atteinte d'une valeur seuil prédéterminée de la valeur détectée par le capteur, une fréquence d'interrogation de la valeur détectée par le capteur.
